# EUROPEAN PATENT APPLICATION

(11) **EP 0 604 397 A2**
(43) Date of publication of application: **29.06.1994**
(21) Application number: 94102774.0
(22) Date of filing: 26.05.1989
(51) Int. Cl.: H03M 1/82, G06J 1/00

(54) **Digital-to-analogue conversion**

(30) Priority: 03.06.1988 GB 8813162
(62) Divisional of application: 89305396.7
(71) Applicant: BRITISH TELECOMMUNICATIONS public limited company, London EC1A 7AJ (GB)
(72) Inventor: Da Franca, Jose de Albuquerque Epifanio, 1900 Lisboa (PT); Vital, Joao Paulo Calado Cordeiro, 1200 Lisboa (PT); Leme, Carlos Mexia de Almeida de Azeredo, 1000 Lisboa (PT)
(74) Representative: Lloyd, Barry George William

(57) **Abstract**

A switched capacitor digital-to-analogue converter employing a single capacitor C, common to a plurality of bits b,b_{w-1}, appropriate weighting of the bits being achieved by switching waveforms A₀ to A_{w-1}.

## Description

This application is a divisional application of European Patent Application No. EP-A-344998 and relates to digital-to-analogue converters and their use in filtering arrangements.

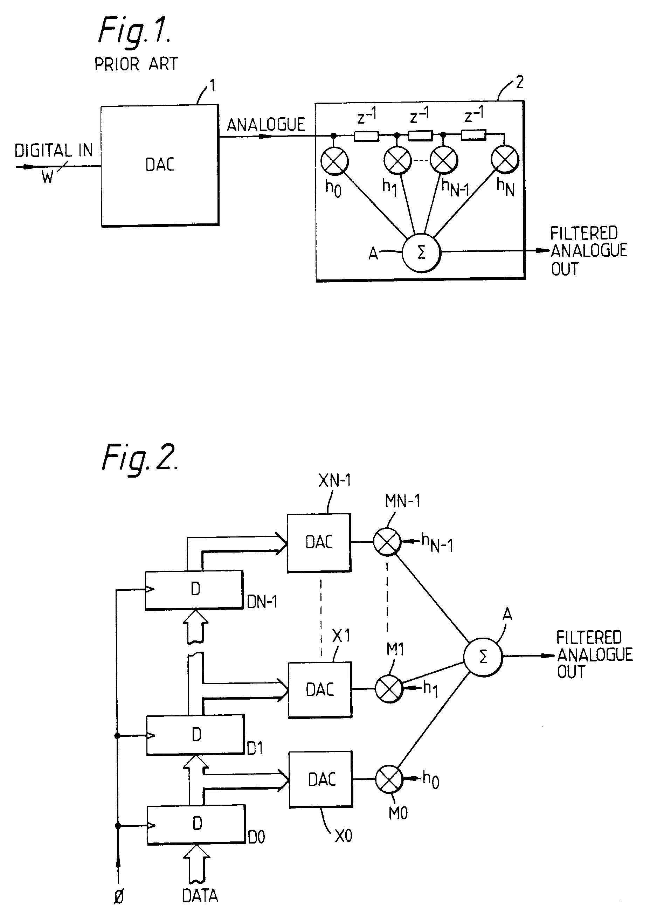

A typical, conventional filtering arrangement is shown in Figure 1, where successive sample values of a w-bit digital word [b₀b₁...bᵢ...b_{w-1}] are supplied to a digital-to-analogue converter (DAC) 1 followed by an analogue FIR (finite impulse response) filter 2, based on a conventional tapped delay line structure with delays z⁻¹, filter coefficient multipliers h₀...h_{N-1} and an adder A (or of course a parallel structure may be used). The coefficients are selected to give any desired filter response; in general this will be a baseband response from DC to half the sampling frequency F_{S}, followed by some rejection of unwanted frequencies above F_{S}/2.

The DAC may employ switched capacitor techniques (as described for example in Roubik Gregorian - "High Resolution Switched Capacitor D/A Converter" - Microelectronics Journal, Vol. 12, No. 2, 1981 Mackintosh Publ. Ltd); in the filter, the analogue delays may also be realised by switched-capacitor elements. The realisation of the analogue delays may however not be ideal.

Alternatively, the delays may be achieved digitally as described in US Patent No. 3,543,009 (Voelcker). An arrangement using this principle shown in Figure 2 and receives, as does that of Figure 1, successive w-bit digital samples of a signal to be converted. The digital words are fed to a chain of N w-bit wide D-type bistable flip-flops DO...DN-1 which are clocked at sampling rate F_{S} with clock pulses Ø, so that a digital word, delayed by a respective number of sample periods, is available at the output of each flip-flop. These outputs are converted into analogue form by digital-to-analogue converters XO...XW-1 which produce at their outputs successive analogue samples corresponding to the digital samples supplied to them. The analogue outputs are multiplied by respective filter coefficients h₀...h_{N-1}; multipliers MO...MN-1 are shown though in the US patent resistors are used. The weighted analogue values are then summed in an adder A.

According to one aspect of the present invention there is provided a switched capacitor digital-to-analogue converter comprising inputs for receiving signals representing respective bits of a digital signal, respective switching means for supplying charge to a capacitor in dependence on the states of those bits, and means for generating an analogue output signal representing the sum of those charges, characterised in that the said capacitor is a single capacitor common to all bits and that the switching means are arranged to supply, in response to each of said inputs, a respective switching waveform, each waveform comprising a different predetermined number of pulses, said number corresponding to the significance of the respective bit such that the charges supplied are weighted according to the significance of the bits.

Preferably the digital signal comprises w bits and the switching waveforms comprise 2ⁱ pulses, where i is an integer from 0 to w.

The digital-to-analogue converter maybe used in a filter apparatus, as described in the parent application. The desired filter response may be achieved by choosing the values of the capacitor in one (or more) switched-capacitor arrangements to have a value different from the corresponding capacitor in another.

Some embodiments of the present invention will now be described, by way of example, with reference to the accompanying drawings, in which: -
- Figure 3 is a circuit diagram of a known switched-capacitor unit;
- Figure 3a illustrates clock pulses used by the unit of Figure 3;
- Figure 4 is a block diagram of a further embodiment of filtered digital-to-analogue converter;
- Figure 5 is a modified version of part of Figure 3, for implementing negative filter coefficients;
- Figure 6 is a circuit diagram of a digital-to-analogue converter unit;
   Figure 7 illustrates the clock and switching pulses employed in the unit of Figure 6;
- Figure 8 is a block diagram of a filtered digital-to-analogue converter employing converter units of the type shown in Figure 6;
- Figure 9 is a modified version of part of Figure 6, for implementing negative filter coefficients;
- Figure 10 illustrates a practical implementation of the converter of Figure 8;
- Figure 11 is a block diagram of a pulse generator for driving the converter of Figure 10; and
- Figure 12 is a state diagram illustrating the operation of the generator of Figure 10.

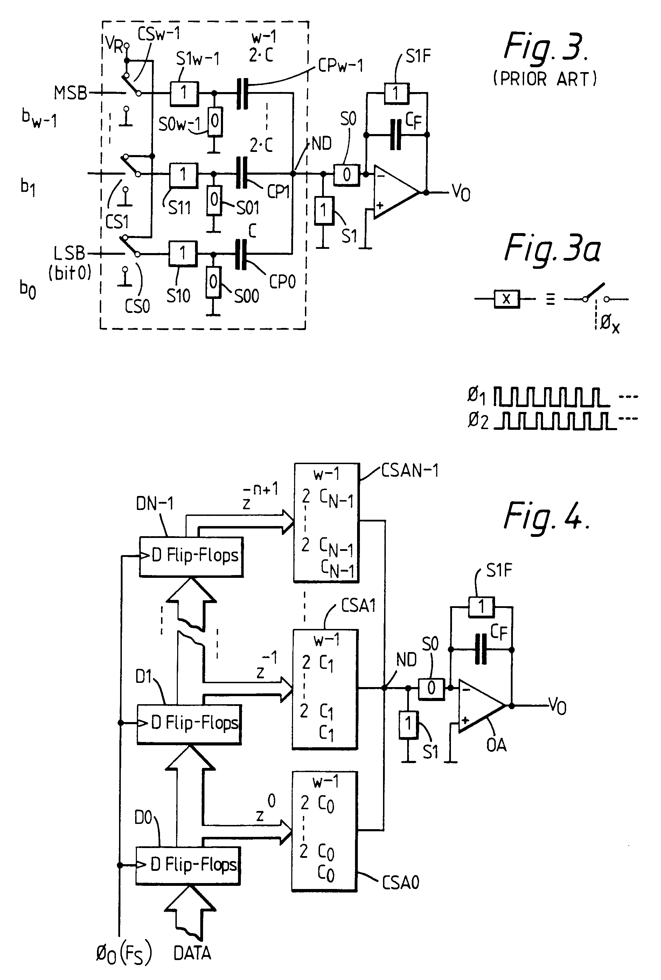

First, the operation of a known type of switched capacitor digital-to-analogue converter will be described with reference to Figure 3, where the input bits of a w-bit digital word are designated b₀...b_{w-1} and each serves to switch, according to its binary value, an electronic switch CSO...CSw-1 (shown schematically) between zero volts (referred to below as "ground") and a reference voltage V_{R}. The converter contains a number of electronic switches controlled by the non-overlapping two-phase clock pulses Ø₀, Ø₁ at the sampling frequency F_{S}, which are shown in Figure 3a. In Figure 3 and elsewhere, the switches are shown as rectangles containing 0 or 1 indicating that the switch is closed during clock phase 0 or 1 respectively. Using the suffix i to indicate generically the components handling signals from one bit (bᵢ) of the input bits b₀...b_{w-1}, the output of each switch CSi is connected via a switch s1i controlled by Ø₁ to one side of a capacitor CPi, which is also connected to ground via a switch SOi controlled by Ø₀. The other side of each capacitor CPi is connected to a common node ND, also connected to ground by a switch S1 controlled by Ø₁. The capacitors have binary weighted values - i.e. the capacitance of the capacitor CPi is 2ⁱ.C where C is the value of the smallest capacitor CPO. The node ND is also connected via a switch SO controlled by Ø₀ to the input of a high gain inverting amplifier OA which has a negative feedback path consisting of a capacitor C_{F} in parallel with a switch S1F controlled by Ø₁.

During clock phase 1, the capacitor C_{F} is discharged via S1F. Also, each capacitor CPi is charged or discharged via switches S1i and S1 to the voltage (O or V_{R}) determined by the respective switch CSi. During clock phase φ₀, the total charge on the capacitors CPi 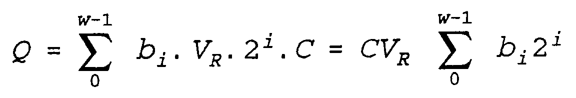
is transferred to the capacitor C_{F} so that the output of the converter is 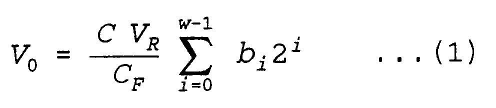
Figure 4 shows a filtered digital-to-analogue conversion apparatus according to a first embodiment of the invention where the node ND, switches S0, S1, S1F, capacitor C_{F} and amplifier OA are common to the N converters. The flip-flops DO...DN-1 are as in Figure 2, whilst the capacitor/switch array units CSAO...CSAN-1 correspond to the components enclosed in the broken line box in Figure 3. In this embodiment, the capacitor values in each array are chosen to weight the contribution of that array to the final output by a factor corresponding to the appropriate one of the desired filter coefficients h₀...h_{N-1}.

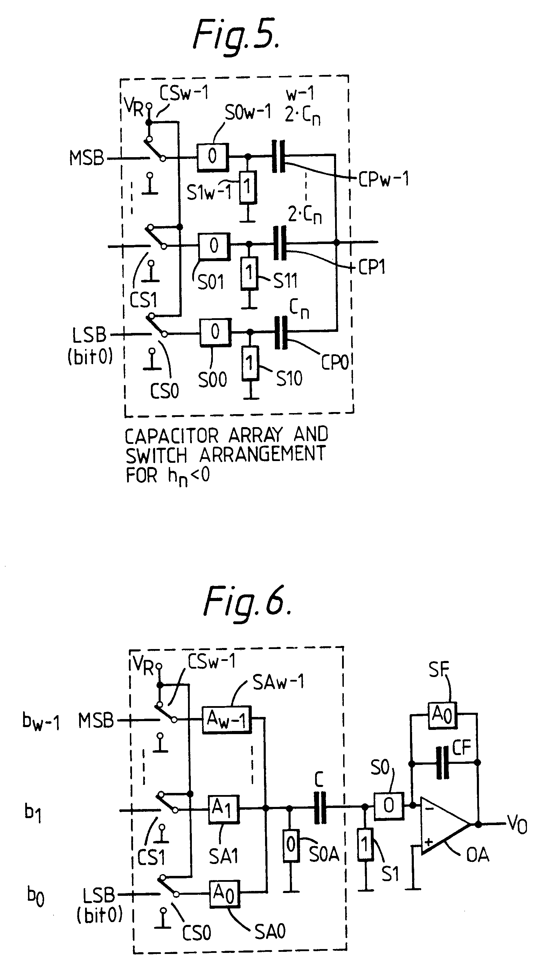

To accommodate negative coefficients, the array is modified by the transposition of the clock phases illustrated in Figure 5 by transposition of switches S0i and S1i. The nth array (n=0,....,N-1) has capacitors with values 2ⁱ.Cₙ where ${\text{C}}_{\text{n}} {\text{= |h}}_{\text{n}} {\text{|.C}}^{\text{*}}$ (C^{*} being a constant), so that the contribution of this array to the total output voltage is 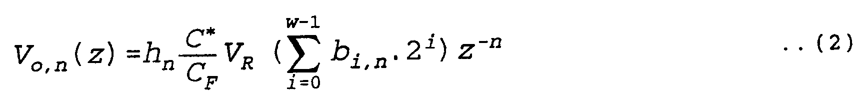
where z is the z-transform variable and b_{i,n} is the value of the ith bit of the digital word at the output of the nth D-type flip-flop. The contribution of all N words for a FIR filter of length N is 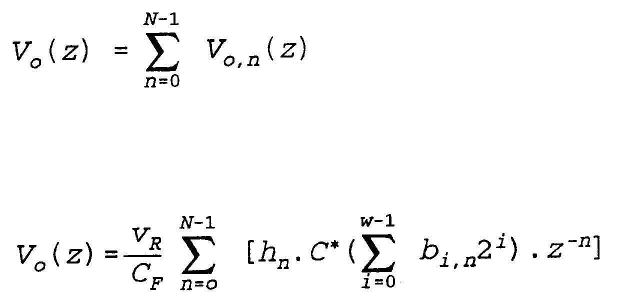
If we set ${\text{C}}_{\text{F}} {\text{=2}}^{\text{w}} {\text{.C}}^{\text{*}}$ then the output voltage is 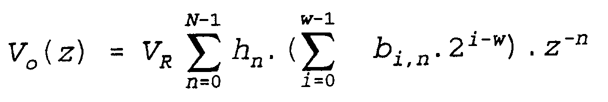
If the smallest capacitance value Cₙ is C, and the corresponding value of hₙ is h_{n min} then the remaining capacitor values are given by 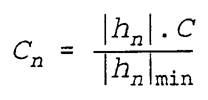
and 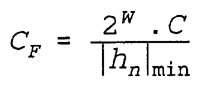
Since C_{F} is usually the largest capacitor in the circuit, we obtain a maximum capacitance spread of 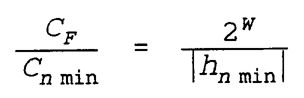
and a total capacitor area of 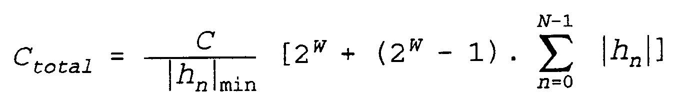
For an example of FIR filtering function with equal coefficients and unity DC gain (hₙ=1/N, n=0, ..., N-1) the above results lead to a capacitance spread of ${\text{C}}_{\text{spread}} {\text{= N.2}}^{\text{w}}$ and a total capacitor area of

${\text{C}}_{\text{total}} {\text{= N.(2}}^{\text{w+1}} \text{-1).C.}$

The embodiment of Figure 4 requires (N.w)+1 capacitors and (2N.w)+3 switches, increasing with both the bit resolution w of the conversion and the length N of the desired filter impulse response. This means that, even for a medium bit resolution and short filter responses, the resulting silicon area required for an integrated circuit implementation can become rather large. An alternative converter is however now proposed, having reduced number of capacitors and switches.

Figure 6 shows a switched capacitor digital-to-analogue converter (without filtering). It can, as will be described in more detail below, be used to replace the converters X0..XN-1 of Figure 2, in the same manner as was the converter of Figure 3.

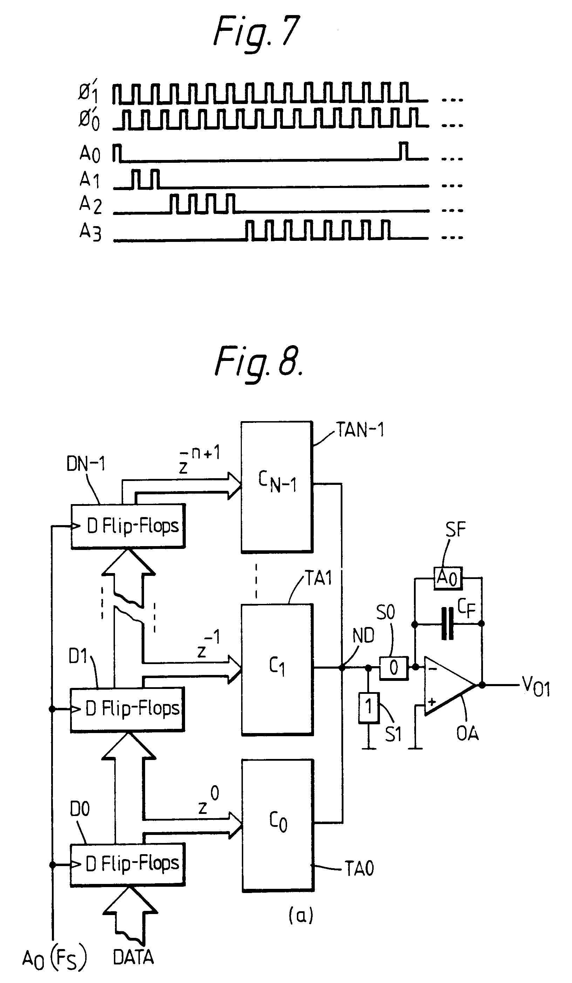

Input bits bᵢ and switches CSi perform the same functions as in Figure 3, as do switches S1, S0, SF, capacitor C_{F} and amplifier OA. However, the capacitors CPi and switches S0ᵢ are replaced by a single capacitor CP and switch S0A. The binary weighting of contribution of the w input bits is instead determined by the waveforms applied to the switches S1i (now designated SA0....SAi...SAw-1). Effectively the capacitor CP is multiplexed between the input bits. A set of switching waveforms φ'₁, φ'₀ and A₀..A_{w-1} for w=3 is illustrated in Figure 7.

Note that there are now 2^{w-1} clock pulses φ₁' (or φ₀') in one conversion period. The waveforms A₀...A_{w-1} contain 1, 2, 4 etc pulses synchronous with φ₁' - ie in general the waveform Aᵢ contains 2ⁱ pulses. At the beginning of each conversion period, the feedback capacitor C_{F} is reset by the switch SF controlled by pulse A₀. Pulse A₀ also closes switch SAO and the capacitor C assumes a voltage of 0 or V_{R} according to the state of bit b₀. On the following clock pulse φ₀' this charge is transferred to C_{F}. This process is repeated by pulse A₁ for bit b₁; however, this occurs twice, as A₁ contains two pulses, and so forth, the D/A conversion being performed sequentially from bit b₀ to bit b_{w-1}. The converted output is available during pulse φ₀ following the last pulse of A_{w-1}, prior to resetting of C_{F} by a further pulse A₀. Of course it is not actually necessary that the bits be processed in any particular sequence, or indeed that all the pulses for one particular bit be generated before those of another bit (though obviously the pulses must not coincide).

The equivalent bit voltage Vᵢ corresponding to each bit of the digital word is determined by the number of pulses of the corresponding switching waveform Aᵢ and can thus be expressed by

${\text{V}}_{\text{i}} {\text{= V}}_{\text{R}} {\text{.b}}_{\text{i}} {\text{.2}}^{\text{i}}$

and therefore the converted output is 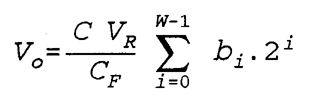
Assuming ${\text{[V₀ max /V}}_{\text{R}} {\text{.(1-2}}^{\text{-N}} \text{)] = 1}$ , we can easily see from the above expression that the capacitance spread of the converter in Figure 6 is equal to the capacitance spread of the conventional converter of Figure 3, ie ${\text{(C}}_{\text{F}} {\text{/C)=2}}^{\text{w}}$ . However, the total capacitor area is now only (2^{w}+1).C, compared to 2^{w+1}.C in a conventional converter, and the total number of capacitors has also been reduced from (w+1) to only 2. An additional significant advantage of this new architecture is that, unlike conventional converters, the accuracy of the capacitance ratio C_{F}/C does not affect the required bit resolution, which depends solely on the number of time slots of each switching waveform. Thus, we can easily apply to the converter of Figure 6 a number of well known design techniques than can significantly reduce the capacitance spread in a switched-capacitor network (eg capacitive-T network), even though this also brings an inherent reduction of the resulting accuracy of the capacitance ratios. This makes it practical to implement high resolution converters using simple switched capacitor networks occupying a small area of silicon.

It is observed that, for a given maximum switching frequency, the conversion rate (and hence sampling rate of the digital words that can be accommodated) is reduced by a factor of (2^{w}-1) relative to Figure 3; however the reduction in capacitor area and required capacitance ratio accuracy make this embodiment particularly useful for high resolution conversions at lower frequency.

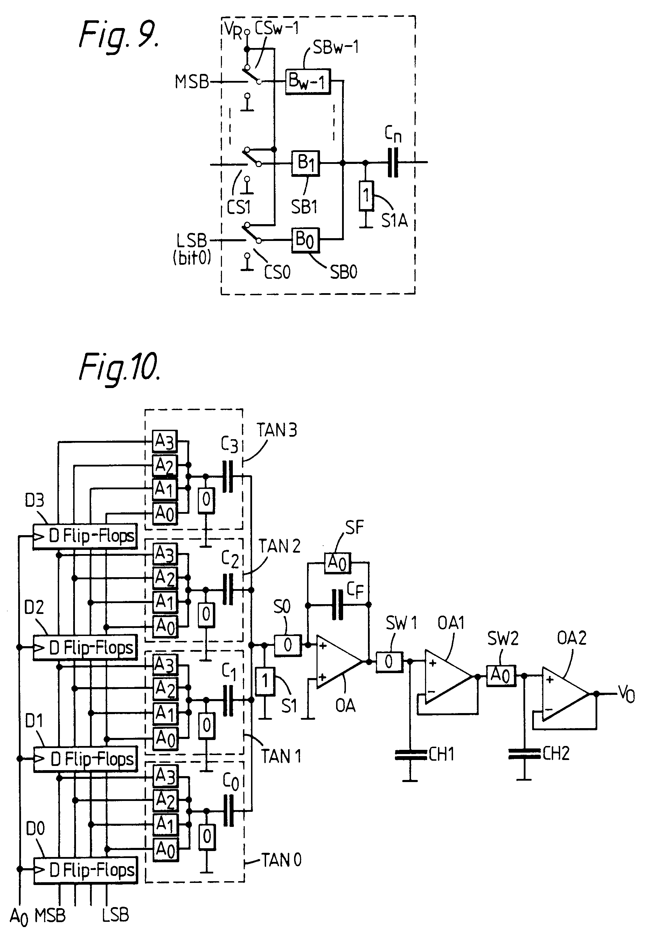

An implementation of a combined digital-to-analogue converter and FIR filter based on the binary-weighted time slot array architecture described above is illustrated in Figure 8. The flip-flops Dn are shown as for Figures 2 and 4. The converters Xn of Figure 2 are replaced by time slot arrays TA0 to TAN-1, followed by common components S1, S0, OA, C_{F} and SF which are identical to those shown in Figure 6. Each time slot array TAi is either in the form indicated in the dotted rectangle in Figure 6 (for positive hₙ) or, for negative hₙ is structurally the same but is supplied with different pulses. Thus switches SAn supplied by pulses Aₙ and switch SOA supplied with pulses φ₀' are replaced by switches SBn and S1A supplied with pulses Bₙ and φ₁', as shown in Figure 9. Pulses Bₙ (n=0...n-1) take the same form as pulses Aₙ but are synchronous with φ₀' instead of φ₁'.

As in the case of the architecture of Figure 2, we can easily see that the normalised output voltage conversion level corresponding to all N digital words is also expressed by 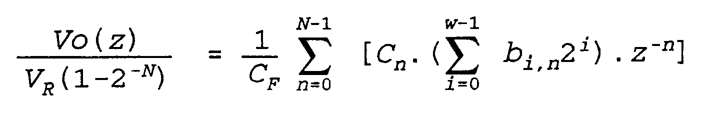
where 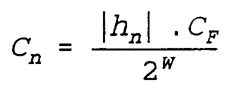
in order to preserve the gain constant of the FIR transfer function. After normalisation, we obtain

${\text{C}}_{\text{n min}} \text{= C}$ 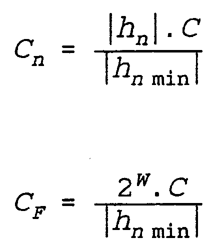
yielding a maximum capacitance spread of 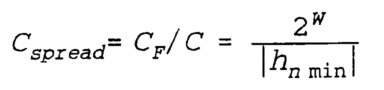
and 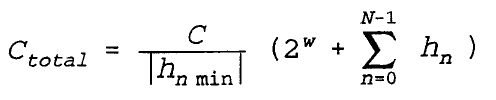
for the total capacitor area. For many practical situations where the FIR filter is designed such that 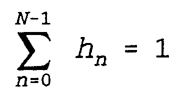
the above expression for Cₜₒₜₐₗ shows a reduction of about 50% over the total capacitor area obtained with the previous realisation. Two additional advantages of the architecture with binary-weighted time slot arrays are obtained firstly with respect to the total number of capacitors, which has been reduced from (N.w+1) to only (N+1), and, secondly, with respect to the required capacitance ratio accuracy of the impulse response coefficients of the FIR filter.

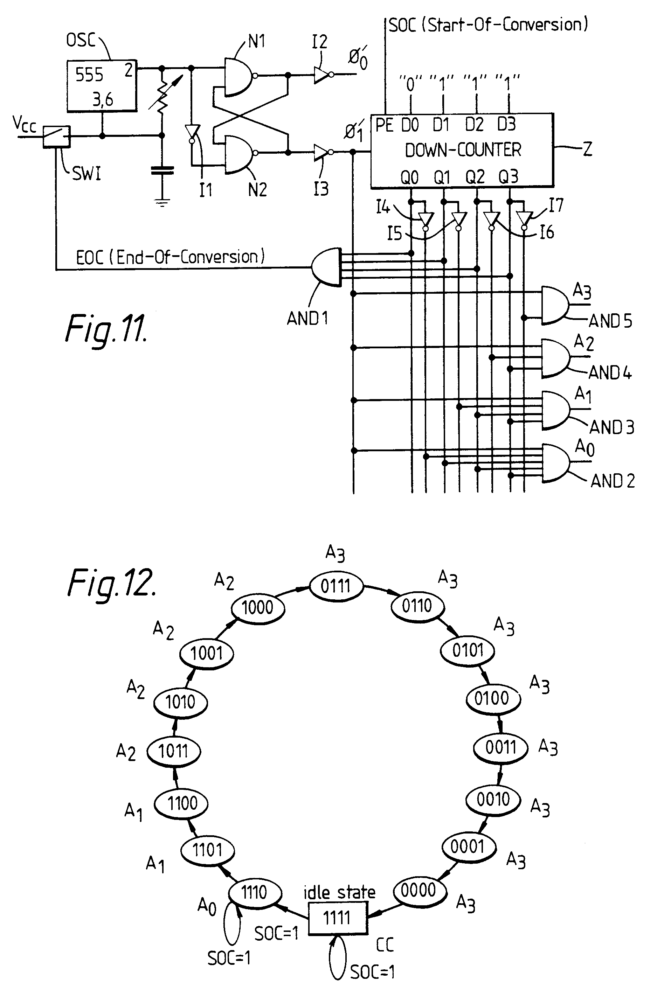

Figures 10 and 11 illustrate a simple practical implementation of the type of combined digital-to-analogue converter described above with reference to figure 8. It has 4-bit resolution and four equal FIR filter coefficients. The filter impulse response (in z-transform notation) is

$\text{H (z) = ¹/4 (1 + z⁻¹ + z⁻² + z⁻³).}$

There are four 4-bit wide D-type flip-flops D0, D1, D2, D3. Note that the first of these is (as in the other figures) not strictly necessary but is included to ensure accurate timing. Also the switches CSi are omitted (on the basis that, for a 4-bit implementation, the voltages output directly from the flip-flops are themselves sufficiently consistent). There are three stages TAN0 ... TAN3, of the type shown in figure 6, with equal capacitor C0 ... C3 (= capacitance C) representing the four equal coefficients. Components S0, S1, SF, CF and OA are as shown in figure 6, whilst two simple sample and hold circuits SW1, CH1, OA1, SW2, CH2, OA2 are included to sample the output (A₀ being applied to switches SW1, SW2) when conversion is completed, to eliminate any output transients during conversion. C_{F} is equal to 64C for ${\text{Vomax/V}}_{\text{R}} {\text{(1 - 2}}^{\text{-N}} \text{) = 1}$ .

The switching waveforms A₀, A₁, A₂, A₃ are generated by means of the generator shown in figure 11. A square-wave oscillator OSC drives a non-overlapping phasing generator consisting of an invertor I1, cross-coupled NAND gates N1, N2, and inverters I2, I3 to produce pulses φ₀, φ₁. A modulo 8 binary down-counter Z is clocked by φ₁. The ' 1111' state is designated as an idle-state in which the counter is locked by an and-gate AND1 which decodes this state to an end of conversion pulse EOC and inhibits clock pulses via a switch SWI in the oscillation circuit.

The generation of the required (2^{w}-1) = 15 pulses of the switching waveforms A₀ ... A₃ is indicated by an external pulse SOC (synchronous with the digital input data to be converted) which is applied to a paralled load input PE of the counter Z1 to load count ' 1110' into the counter.

The counter is then decremented by pulses φ₁ through its states to 000, during which period the counter states are decoded by inverters I4 ... I7 and and-gates AND2 ... AND4 to produce the pulses A₀ ... A₃ as illustrated in the sequence diagram in figure 12. The sixteenth pulse φ₁ returns the counter to the ' 1111' state where it remains locked until a further start pulse SOC is received.

Note that in this converter, pulses Bᵢ are not required (since the filter coefficients are all positive) but could of course be generated by a second counter and decoding logic similar to the arrangements for Aᵢ.

A discrete component version of this converter can be constructed using amplifiers type LF353, CMOS analogue switches type CD4016, and standard CMOS logic circuits, although in practice an integrated circuit implementation is to be preferred.

Typical capacitor values are C = 40pF and C_{F} = 2700pF (with ± 0.2% of the nominal values) may be used.

## Claims

1. A switched capacitor digital-to-analogue converter comprising inputs for receiving signals representing respective bits of a digital signal, respective switching means (CS1...CSw-1, SA0...SAw-1) for supplying charge to a capacitor in dependence on the states of those bits, and means for generating an analogue output signal representing the sum of those charges, characterised in that the said capacitor is a single capacitor (C) common to all bits and that the switching means (CSi, SAi) are arranged to supply, in response to each of said inputs, a respective switching waveform (A₀ to A_{w-1}), each waveform comprising a different predetermined number of pulses, said number corresponding to the significance of the respective bit such that the charges supplied are weighted according to the significance of the bits.

2. A digital-to-analogue converter according to Claim 1 wherein the digital signal comprises w bits and the switching waveforms comprise 2ⁱ pulses, where i is an integer from 0 to w.

3. A digital-to-analogue converter according to Claim 1 or 2 wherein the switching waveforms are supplied sequentially for each bit of the digital signal.

4. An apparatus for producing a filtered analogue output signal from a digital signal in the form of a sequence of digital signal samples each having a plurality of bits comprising digital delay means (D0...DN-1) for producing further sequences of digital signal samples, each being a replica of the first sequence delayed with respect thereto by a respective delay period, a plurality of switched capacitor digital-to-analogue converters as claimed in any of claims 1 to 3, each connected to receive a respective one of the said sequences of digital signal samples and the total charge of each switched capacitor digital-to-analogue converter being weighted to weight the contribution of each converter by a factor corresponding to a respective one of a set of coefficients corresponding to a desired filter response, and common summing means (S0, S1, SIF or SF, CF, OA) for receiving the charges from all the switched capacitor digital-to-analogue converters and forming an analogue output sequence representing the sum of those charges.

5. An apparatus according to Claim 6, characterised in that the capacitor in at least one of the switched capacitor digital-to-analogue converters differs in value from the corresponding capacitor in another of the switched capacitor digital-to-analogue converters, such as to weight the charges by factors corresponding to the said coefficients.
